# EUROPÄISCHE PATENTSCHRIFT

(11) **EP 2 391 900 B1**
(45) Veröffentlichungstag und Bekanntmachung des Hinweises auf die Patenterteilung: **05.09.2012**
(21) Anmeldenummer: 10700739.5
(22) Anmeldetag: 14.01.2010
(51) Int. Cl.: G01R 31/36, H01M 10/48

(54) **Verfahren zur Bestimmung einer charakteristischen Zustandsgrösse einer Speichereinheit**
Method of determining a characteristic status parameter of a battery
Procédé pour déterminer un paramètre d'état caractéristique d'une batterie

(30) Priorität: 28.01.2009 DE 102009000451
(43) Veröffentlichungstag der Anmeldung: 07.12.2011
(73) Patentinhaber: Robert Bosch GmbH, 70442 Stuttgart (DE)
(72) Erfinder: BUTZMANN, Stefan, 71717 Beilstein (DE)
(86) Internationale Anmeldenummer: PCT/EP2010/050384
(87) Internationale Veröffentlichungsnummer: WO 2010/086230

(56) Entgegenhaltungen:
- WO-A1-2008/130711
- DE-A1- 2 745 003
- DE-A1- 10 228 351
- US-A- 5 250 903
- US-A- 5 537 042

## Beschreibung

Die Erfindung betrifft ein Verfahren zur Bestimmung einer charakteristischen Zustandsgröße einer Speichereinheit mittels einer elektrischen Schaltungsanordnung.

### Stand der Technik

Bei einem derartigen Verfahren wird als charakteristische Zustandsgröße der Alterungszustand der Speichereinheit mittels einer elektrischen Schaltungsanordnung bestimmt. Die elektrische Speichereinheit ist dabei eine einzelne elektrische Speicherzelle oder mehrere miteinander elektrisch verschaltete Speicherzellen, insbesondere ein elektrischer Speicher. Ein derartiger elektrischer Speicher ist zum Beispiel eine wiederaufladbare Batterie.

Ein Problem beim Einsatz von Batterien in stationären Anwendungen, wie z. B. bei Windkraftanlagen oder in Fahrzeugen, wie zum Beispiel Hybrid- oder Elektrofahrzeugen, stellt die Bestimmung des Alterungszustands der einzelnen Speicherzellen (Batteriezellen) dar. Der Alterungszustand ist eine charakteristische Zustandsgröße der Speicherzelle und wird in geeigneter Weise durch Bestimmung des Innenwiderstands der einzelnen Speichereinheiten, insbesondere Speicherzellen, durch Einprägung von Strömen unterschiedlicher Frequenz mit hinreichender Genauigkeit abgeschätzt. Dieses Verfahren wird mittels aufwendiger Laboraufbauten in Validierungs- und Testumgebungen durchgeführt. Hierzu wird die Speichereinheit, deren Alterungszustand bestimmt werden soll, mit Hochleistungsstromquellen stimuliert, und der Innenwiderstand mittels der ermittelten Spannungsänderung über den einzelnen Speichereinheiten bestimmt. DE 27 45 003 offenbart ein Verfahren und eine Schaltungs-anordnung zur Prüfung des Ladezustandes eines Primär-elementes.

### Offenbarung der Erfindung

Das erfindungsgemäße Verfahren wie in Anspruch 1 definiert, erfolgt mittels einer Schaltungsanordnung, in der mindestens ein induktives Bauelement und mindestens ein kapazitives Bauelement angeordnet sind, die mit der Speichereinheit einen Schwingkreis bilden, wobei das Verfahren die folgenden Schritte aufweist: Anregen des Schwingkreises durch temporäre Ladungsbeaufschlagung des kapazitiven Bauelements, wobei die Anregung mittels einer von der Speichereinheit elektrisch gespeisten Anregungsvorrichtung erfolgt, Ermitteln einer zeitabhängigen Spannungsänderung an dem kapazitiven Bauelement nach Beendigung der Anregung und Bestimmen der charakteristischen Zustandsgröße aus der Zeitabhängigkeit der Spannungsänderung. Bei einem derartigen Verfahren erfolgt die Anregung der Speichereinheit energieeffizient und aufwandsarm. Weiterhin kann das Verfahren für verschiedene Frequenzen verwendet werden. Da die Anregungsvorrichtung von der elektrischen Speichereinheit selbst elektrisch gespeist, also mit elektrischer Energie versorgt wird, entfällt eine zusätzliche Energieversorgung. Da der Schwingkreis durch eine temporäre Ladungsbeaufschlagung kapazitiven Bauelements und nicht durch eine periodische Anregung zum Schwingen angeregt wird, ist diese Anregung für Schwingkreise unterschiedlicher Eigenfrequenz anwendbar.

Die elektrische Speichereinheit ist eine Einheit eines elektrischen Speichers, der als kleinste Einheit eine einzelne elektrische Speicherzelle eines elektrischen Speichers umfasst und als größtmögliche Einheit der elektrische Speicher selbst ist. Der elektrische Speicher ist insbesondere eine wiederaufladbare Batterie, die aus einzelnen Batteriezellen aufgebaut ist. Das kapazitive Bauelement ist insbesondere ein Kondensator oder eine Kondensator-Schaltungsanordnung, das induktive Bauelement ist insbesondere eine Spule oder eine Spulenschaltungsanordnung. Das induktive Bauelement weist eine bekannte Induktivität L, das kapazitive Bauelement eine bekannte Kapazität C auf.

Insbesondere ist vorgesehen, dass die charakteristische Zustandsgröße ein Ladezustand (SOC: State of Charge) und/oder ein Alterungszustand und/oder ein Gesundheitszustand (SOH: State of Health) der Speichereinheit ist. Bevorzugt ist die charakteristische Zustandsgröße der Alterungszustand der Speichereinheit, da dieser Alterungszustand die deutlichste Abhängigkeit von dem Innenwider stand der elektrischen Speichereinheit zeigt.

Gemäß einer bevorzugten Ausführungsform der Erfindung ist vorgesehen, dass mindestens ein weiteres kapazitives Bauelement der Schaltungsanordnung zugeschaltet wird und der Schwingkreis zur Bestimmung der Größe aus der veränderten zeitabhängigen Spannungsänderung anschließend erneut angeregt wird. Durch das Zuschalten des weiteren kapazitiven Bauelements ergibt sich eine geänderte Eigenfrequenz des Schwingkreises und somit eine veränderte zeitabhängige "Trägerfrequenz" der Spannungsänderung.

Vorzugsweise wird der Schwingkreis nach dem Ermitteln der zeitabhängigen Spannungsänderung durch Zuschalten mindestens eines elektrischen Widerstands mit einem gegenüber dem Innenwiderstand der Speichereinheit höheren Widerstandswert gedämpft. Durch diese zusätzliche Dämpfung baut sich der Strom im Schwingkreis schnell ab.

Weiterhin ist mit Vorteil vorgesehen, dass die Anregungsvorrichtung ein anderes induktives Bauelement aufweist, welches durch einen Kurzschlussstrom ein magnetisches Feld aufbaut, wobei dieses Feld nach Abschalten des Kurzschlussstroms einen Stromfluss generiert, der das kapazitive Bauelement temporär mit Ladung beaufschlagt. Das sich nach Abschalten des Kurzschlussstroms abbauende Magnetfeld induziert eine Spannung, die den Stromfluss generiert. Dieser sorgt für einen Ladungstransfer auf das kapazitive Bauelement. Um ein anschließendes Abfließen der Ladung zu verhindern, ist zwischen dem anderen induktiven Bauelement und dem kapazitiven Bauelement eine Diode zwischengeschaltet.

Die elektrische Speichereinheit ist eine Einheit eines elektrischen Speichers, insbesondere einer wiederaufladen Batterie. Die kleinste Speichereinheit ist eine einzelne Speicherzelle, die größte Speichereinheit der elektrische Speicher selbst. Das induktive Bauelement weist eine bekannte Induktivität, das kapazitive Bauelement eine bekannte Kapazität auf. Die Anregungsvorrichtung wird bevorzugt von einer Teilspannung des elektrischen Speichers gespeist. Zum Abgriff dieser Teilspannung weist die Speichereinheit mindestens einen Zwischenabgriff auf, wobei die Anregungsvorrichtung über diesen Zwischenabgriff und mindestens einen weiteren Abgriff der Speichereinheit elektrisch gespeist wird.

Gemäß einer bevorzugten Ausführungsform der Erfindung ist vorgesehen, dass die Anregungsvorrichtung einen über Anregungsleitungen parallel zum kapazitiven Bauelement geschalteten Kurzschlussstrompfad mit einem Schalter aufweist und über Versorgungsleitungen mit der Speichereinheit verbunden ist, wobei eine der Anregungsleitungen eine Diode und eine mit dieser Anregungsleitung verbundene Versorgungsleitung ein weiteres induktives Bauelement aufweist. Durch Schließen des im Kurzschlussstrompfad angeordneten Schalters ergibt sich ein Kurzschlussstrom, der in dem weiteren induktiven Bauelement ein magnetisches Feld aufbaut. Wird der Schalter in Kurzschlussstrompfad anschließend geöffnet, so wird der Kurzschlussstrom abgeschaltet und das sich abbauende magnetische Feld induziert eine Spannungsspitze, die deutlich höher als die Spannung der Speichereinheit ist. Diese Spannungsspitze generiert einen Strom durch die Anregungsleitung mit der Diode, der das kapazitive Bauelement der Schaltungsanordnung temporär mit Ladung beaufschlagt. Ein anschließendes Rückfließen der Ladungen in Richtung des weiteren induktiven Bauelements wird durch die in diese Richtung sperrende Diode verhindert.

Gemäß einer weiteren vorteilhaften Ausgestaltung der Erfindung ist vorgesehen, dass die Schaltungsanordnung mindestens einen parallel zum kapazitiven Bauelement geschalteten weiteren Strompfad besitzt, der ein weiteres kapazitives Bauelement und einen weiteren Schalter in Serienschaltung aufweist. Durch diesen weiteren Strompfad ist ein zuschaltbares weiteres kapazitives Bauelement realisiert. Die sich ergebende Parallelschaltung des kapazitiven Bauelements und des zugeschalteten kapazitiven Bauelements weist eine Gesamtkapazität auf, die der Summe der Kapazitäten des kapazitiven Bauelements und des weiteren kapazitiven Bauelements entspricht. Durch diese geänderte Gesamtkapazität ergibt sich ein Schwingkreis mit anderer Eigenfrequenz.

Weiterhin ist mit Vorteil vorgesehen, dass die Schaltungsanordnung mindestens einen parallel zum induktiven Bauelement geschalteten Dämpfungsstrompfad besitzt, der ein Widerstandselement mit einem gegenüber dem Innenwiderstand höheren Widerstandswert und einen Schalter in Serienschaltung aufweist. Der Strom durch den Schwingkreis kann durch Schließen des in Dämpfungsstrompfad angeordneten Schalters schnell auf Null reduziert werden.

Schließlich ist mit Vorteil vorgesehen, dass die Schaltungsanordnung eine Messeinrichtung aufweist, die zur Ermittlung einer zeitabhängigen Spannungsänderung an dem kapazitiven Bauelement mit diesem kapazitiven Bauelement verschaltet ist. Diese Messeinrichtung ist bevorzugt mit einer Auswerteeinrichtung zur Bestimmung der charakteristischen Zustandsgröße verbunden.

Die Erfindung wird nachfolgend anhand der zugehörigen Zeichnungen näher erläutert. Es zeigen:
- Fig. 1: eine elektrische Speichereinheit und eine elektrische Schaltungs-anordnung mit einem ein induktives und ein kapazitives Bauelement aufweisenden Strompfad, der mit der Speichereinheit verbunden ist und mit dieser einen Schwingkreis bildet und
- Fig. 2: ein Diagramm, bei dem die zeitabhängige Spannungsänderung am kapazitiven Bauelement der Fig. 1 nach jeweiliger Anregung über der Zeit aufgetragen ist.

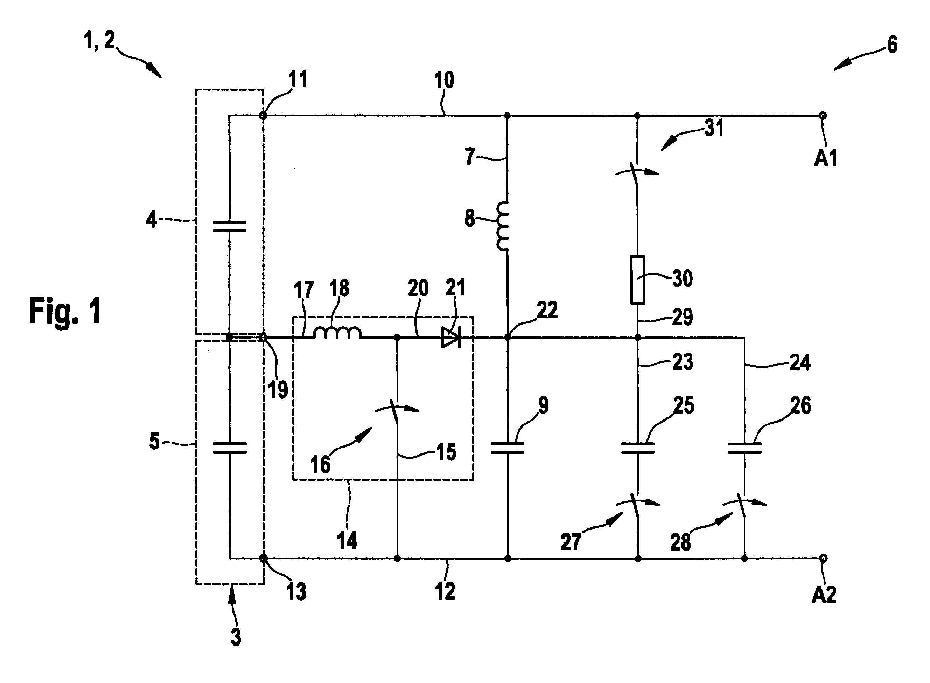

Die Fig. 1 zeigt einen als wiederaufladbarer Batterie 1 ausgebildeten elektrischen Speicher 2 zur elektrischen Versorgung einer nicht gezeigten elektrischen Maschine eines Elektroantriebs eines Kraftfahrzeugs. Der elektrische Speicher 2 wird von einer elektrischen Speichereinheit 3 mit elektrischen Speicherzellen 4, 5 gebildet. Die Speicherzellen 4,5 der wiederaufladbaren Batterie 1 sind dabei zwei Batteriezellen.

Die Fig. 1 zeigt weiterhin eine elektrische Schaltungsanordnung 6, die im Kraftfahrzeug zwischen der elektrischen Speichereinheit 3 und einem nicht gezeigten Betriebsbordnetz des Elektroantriebs zwischengeschaltet ist. Die elektrische Schaltungsanordnung 6 weist einen Strompfad 7 auf, in dem ein als Spule ausgebildetes induktives Bauelement 8 und ein als Kondensator ausgebildetes kapazitives Bauelement 9 in Serienschaltung angeordnet sind. Der Strompfad 7 ist mittels einer ersten Anschlussleitung 10 an einem positiven Kontaktelement 11 der elektrischen Speichereinheit 3 und über eine zweite Anschlussleitung 12 an ein negatives Kontaktelement 13 der elektrischen Speichereinheit 3 angeschlossen. Die Anschlussleitungen 10, 12 verbinden weiterhin die Speichereinheit 3 mit einem nicht gezeigten Betriebsbordnetz des Kraftfahrzeugs, der über Anschlüsse A1, A2 anschließbar ist.

Die elektrische Schaltungsanordnung 6 weist weiterhin eine Anregungsvorrichtung 14 zur Schwindungsanregung eines von dem induktiven Bauelement 8, dem kapazitiven Bauelement 9 und einem Innenwiderstand der elektrischen Speichereinheit 3 gebildeten elektrischen Schwingkreises. Die Anregungsvorrichtung weist einen Kurzschlussstrompfad 15 auf, der parallel zum kapazitiven Bauelement 9 der zweiten elektrischen Speicherzelle 5 geschaltet ist. Der Kurzschlussstrompfad 15 weist einen Schalter 16 auf und ist einerseits über die als Masseleitung ausgebildete zweite Anschlussleitung 12 mit negativen Kontaktelementen 13 der elektrischen Speichereinheit 3 und dem kapazitiven Bauelement 9 verbunden. Der Kurzschlussstrompfad 15 ist andererseits über eine Versorgungsleitung 17, in der ein weiteres induktives Bauelement 18 angeordnet ist, mit einem Zwischenabgriff 19 und über eine Anregungsleitung 20, in der eine einen Strom in Richtung des Kurschlussstrompfades 15 und des weiteren induktiven Bauelements 18 sperrende Diode 21 aufweist, mit dem Strompfad 7 in einem Knotenpunkt 22 verbunden. Parallel zu dem kapazitiven Bauelement 9 sind zwei weitere Strompfade 23,24 geschaltet, die jeweils ein weiteres kapazitives Bauelement 25,26 und jeweils eine Serienschaltung mit dem zugeordneten kapazitiven Bauelement 25,26 geschalteten weiteren Schalter 27, 28 aufweisen.

Weiterhin weist die Schaltungsanordnung 6 einen parallel zum induktiven Bauelement 8 geschalteten Dämpfungsstrompfad 29 auf, der ein Widerstandselement 30 mit einem gegenüber dem Innenwiderstand R der elektrischen Speichereinheit 3 höheren Widerstandswert und einen Schalter 31 zum Zuschalten des Widerstandselements 30 aufweist.

Es ergibt sich folgende Funktion: Die Anregung des Schwingkreises erfolgt über das weitere induktive Bauelement 18, den Schalter 16 in Kurzschlussstrompfad 15 sowie die Diode 21. Das weitere induktive Bauelement 18 ist auf einem Potential kleiner der Gesamtspannung der elektrischen Speichereinheit 3 angeschlossen, in Fig. 1 exemplarisch an der halben Gesamtspannung der elektrischen Speichereinheit 3.

Zu Beginn des Verfahrens zur Bestimmung der vom Innenwiderstand der Speichereinheit 3 abhängigen charakteristischen Zustandsgröße, hier des Alterungszustands, ist der Strom I durch das induktive Bauelement 8 Null (I = 0 A) und die Spannung über dem kapazitiven Bauelement 9 gleicht der Gesamtspannung der elektrischen Speichereinheit 3. Der Schalter 16 im Kurzschlussstrompfad wird temporär geschlossen. In diesem Betriebsmodus baut der Strom durch das weitere induktive Bauelement 18 ein magnetisches Feld auf. Wird der Schalter 16 im Kurzschlussstrompfad 15 wieder geöffnet, fließt ein durch die Induktivität L2 des weiteren induktiven Bauelements 18 hervorgerufener Strom durch die Diode 21 auf das kapazitive Bauelement 9 und lädt dieses auf eine Spannung größer der Gesamtspannung der elektrischen Speichereinheit 3 auf. Dem aus dem induktiven Bauelement 8, dem kapazitiven Bauelement 9 und dem inneren Widerstand der elektrischen Speichereinheit 3 gebildeten Schwingkreis wird damit Energie zugeführt. Die Menge der zugeführten Energie wird durch ein Zeitintervall bestimmt, in dem der Schalter 16 im Kurzschlussstrompfad 15 geschlossen ist.

Damit beginnt nun auch ein Strom durch das induktive Bauelement 8 des Schwingkreises zu fließen, dessen Eigenfrequenz durch die Induktivität L des induktiven Bauelements 8 und die Kapazität C des kapazitiven Bauelements 9 bestimmt ist. Am kapazitiven Bauelement 9 wird mittels einer nicht gezeigten Messeinrichtung eine zeitabhängige Spannungsänderung durch Messung ermittelt. Eine ebenfalls nicht gezeigte Auswerteeinrichtung bestimmt daraus die charakteristische Zustandsgröße des Alterungszustands der elektrischen Speichereinheit 3. Die Zustandsgröße ist eine den Innenwiderstand bestimmende Größe. Die Zustandsgröße und der innere Widerstand der Speichereinheit sind daher voneinander abhängige Größen.

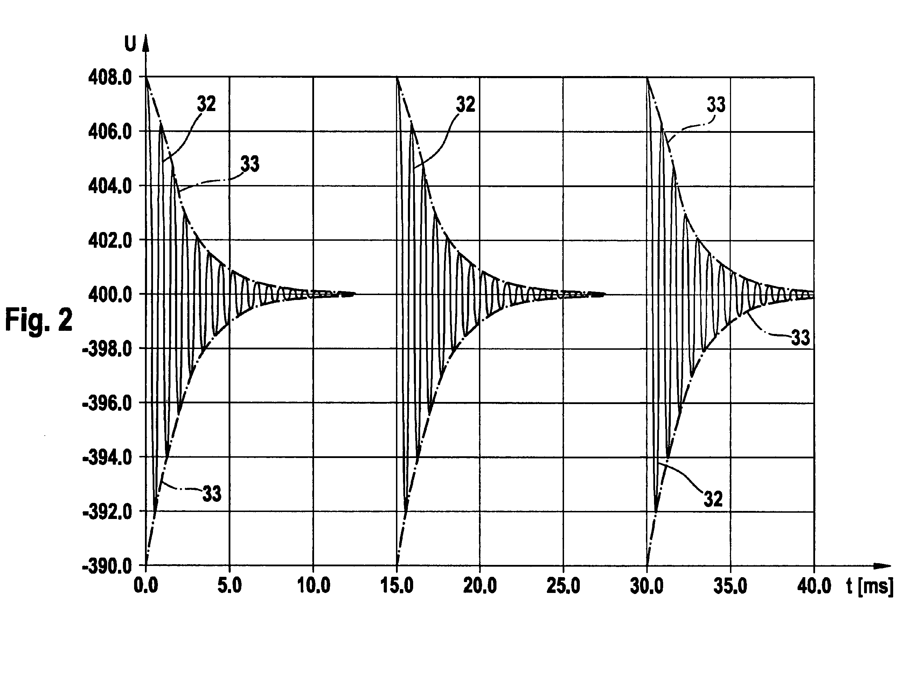

Die Fig. 2 zeigt den Spannungsverlauf 32 der Spannung am kapazitiven Bauelement 9 in Abhängigkeit von der Zeit t bei geschlossenem Schalter 31 des Dämpfungsstrompfades 29, bei dem der Schwingkreis alle 15 Sekunden durch Schließen und anschließendes Öffnen des Schalters 16 in Kurzschlussstrompfad 15 angeregt wird. Der Spannungsverlauf 32 nach jeder Anregung ist durch eine periodische Schwingung mit der Eigenfrequenz des Schwingkreises als Trägefrequenz und durch eine exponentiell abfallende "Einhüllende" 33 bestimmt. Die Eigenfrequenz des Schwingkreises wird von der Induktivität L des induktiven Bauelements und der Kapazität C des kapazitiven Bauelements bestimmt, während die die Einhüllende bestimmende Dämpfung von dem ohmschen Widerstandswert und der Kapazität C des Schwingkreises bestimmt wird. Ist das Widerstandselement 30 des Dämpfungspfades 29 nicht zugeschaltet, so wird dieser ohmsche Widerstandswert vom inneren Widerstand R der Speichereinheit 3 bestimmt.

## Patentansprüche

1. Verfahren zur Bestimmung einer charakteristischen Zustandsgröße einer Speichereinheit (3) mittels einer elektrischen Schaltungsanordnung (6), der mindestens ein induktives Bauelement (8) und mindestens ein kapazitives Bauelement (9) angeordnet sind, die mit der Speichereinheit einen Schwingkreis bilden, mit folgenden Schritten:
- Anregen des Schwingkreises durch temporäre Ladungsbeaufschlagung des kapazitiven Bauelements, wobei die Anregung mittels einer von der Speichereinheit elektrisch gespeisten Anregungsvorrichtung (14) erfolgt,
- Ermitteln einer zeitabhängigen Spannungsänderung (32) an dem kapazitiven Bauelement nach Beendigung der Anregung und
- Bestimmen der charakteristischen Zustandsgröße aus der Zeitabhängigkeit der Spannungsänderung (32).

2. Verfahren nach Anspruch 1, **dadurch gekennzeichnet, dass** die charakteristische Zustandsgröße ein Ladezustand und/oder ein Alterungszustand und/oder ein Gesundheitszustand der Speichereinheit (3) ist.

3. Verfahren nach einem der vorhergehenden Ansprüche, **dadurch gekennzeichnet, dass** mindestens ein weiteres kapazitives Bauelement (25,26) Schaltungsanordnung zugeschaltet wird und der Schwingkreis zur Bestimmung der Größe aus der veränderten zeitabhängigen Spannungsänderung anschließend erneut angeregt wird.

4. Verfahren nach einem der vorhergehenden Ansprüche, **dadurch gekennzeichnet, dass** der Schwingkreis nach dem Ermitteln der zeitabhängigen Spannungsänderung durch Zuschalten mindestens eines elektrischen Widerstands (30) mit einem gegenüber dem Innenwiderstand der Speichereinheit höheren Widerstandswert gedämpft wird.

5. Verfahren nach einem der vorhergehenden Ansprüche, **dadurch gekennzeichnet, dass** die Anregungsvorrichtung ein anderes induktives Bauelemente (18) aufweist, welches durch einen Kurzschlussstrom ein magnetisches Feld aufbaut, wobei dieses Feld nach Abschalten des Kurzschlussstroms einen Stromfluss generiert, der das kapazitive Bauelement (9) temporär mit Ladung beaufschlagt.

## Claims

1. Method for determining a characteristic state variable of a storage unit (3) by means of an electrical circuit arrangement (6), in which at least one inductive component (8) and at least one capacitive component (9), which form a resonant circuit with the storage unit, are arranged, having the following steps:
- exciting the resonant circuit by temporarily applying charge to the capacitive component, the excitation being effected using an excitation apparatus (14) which is electrically fed by the storage unit,
- determining a time-dependent voltage change (32) at the capacitive component after the end of excitation, and
- determining the characteristic state variable from the time dependence of the voltage change (32).

2. Method according to Claim 1, **characterized in that** the characteristic state variable is a state of charge and/or an ageing state and/or a state of health of the storage unit (3).

3. Method according to one of the preceding claims, **characterized in that** at least one further capacitive component (25, 26) of the circuit arrangement is connected, and the resonant circuit is then excited again in order to determine the variable from the changed time-dependent voltage change.

4. Method according to one of the preceding claims, **characterized in that**, after the time-dependent voltage change has been determined, the resonant circuit is attenuated by connecting at least one electrical resistor (30) having a resistance value which is higher than the internal resistance of the storage unit.

5. Method according to one of the preceding claims, **characterized in that** the excitation apparatus has another inductive component (18) which builds up a magnetic field as a result of a short-circuit current, this field generating, after the short-circuit current has been switched off, a flow of current which temporarily applies charge to the capacitive component (9).

## Revendications

1. Procédé pour déterminer une grandeur d'état caractéristique d'une unité d'accumulation (3) au moyen d'un arrangement de commutation électrique (6) dans lequel sont disposés au moins un composant inductif (8) et au moins un composant capacitif (9), lesquels forment, avec l'unité d'accumulation, un circuit oscillant, comprenant les étapes suivantes :
- excitation du circuit oscillant par mise en charge temporaire du composant capacitif, l'excitation s'effectuant au moyen d'un dispositif d'excitation (14) alimenté électriquement par l'unité d'accumulation,
- détermination d'une variation de tension en fonction du temps (32) aux bornes du composant capacitif après la fin de l'excitation et
- détermination de la grandeur d'état caractéristique à partir de la dépendance au temps de la variation de tension (32).

2. Procédé selon la revendication 1, **caractérisé en ce que** la grandeur d'état caractéristique est un état de charge et/ou un état de vieillissement et/ou un état de santé de l'unité d'accumulation (3).

3. Procédé selon l'une des revendications précédentes, **caractérisé en ce qu'**au moins un composant capacitif supplémentaire (25, 26) est connecté à l'arrangement de commutation et le circuit oscillant est ensuite de nouveau excité pour déterminer la grandeur à partir de la variation de tension en fonction du temps modifiée.

4. Procédé selon l'une des revendications précédentes, **caractérisé en ce que** le circuit oscillant, après avoir déterminé la variation de tension en fonction du temps, est amorti en connectant au moins une résistance électrique (30) ayant une valeur de résistance supérieure à la résistance interne de l'unité d'accumulation.

5. Procédé selon l'une des revendications précédentes, **caractérisé en ce que** le dispositif d'excitation présente un autre composant inductif (18) qui établit un champ magnétique par un courant de court-circuit, ce champ générant, après la désactivation du courant de court-circuit, un flux de courant qui met temporairement en charge le composant capacitif (9).
